# EUROPEAN PATENT APPLICATION

(11) **EP 3 059 289 A1**
(43) Date of publication of application: **24.08.2016**
(21) Application number: 14860347.5
(22) Date of filing: 31.10.2014
(51) Int. Cl.: C09D 5/24, B22F 1/02, B22F 9/24, C09D 7/12, H01B 1/00, H01B 1/22, H01B 13/00, H05K 1/09, H05K 3/12

(54) **COPPER PARTICLE DISPERSION AND METHOD FOR PRODUCING CONDUCTIVE FILM USING SAME**

(30) Priority: 06.11.2013 JP 2013229876; 29.10.2014 JP 2014220358
(71) Applicant: DOWA Electronics Materials Co., Ltd., Chiyoda-ku Tokyo 101-8617 (JP)
(72) Inventor: FUJITA, Hidefumi, Okayama-shi Okayama 702-8053 (JP); KANEDA, Shuji, Okayama-shi Okayama 702-8032 (JP); ITOH, Daisuke, Okayama-shi Okayama 700-0912 (JP)
(74) Representative: Manitz, Finsterwald & Partner GbR
(86) International application number: PCT/JP2014/079657
(87) International publication number: WO 2015/068826

(57) **Abstract**

A copper particle dispersing solution obtained by dispersing fine copper particles having an average particle diameter of 1 to 100 nm, each of the fine copper particles being coated with an azole compound, such as benzotriazole, and coarse copper particles having an average particle diameter of 0.3 to 20 *µ*m in a dispersing medium, such as ethylene glycol, so as to cause the total amount of the fine copper particles and coarse copper particles to be 50 to 90 % by weight and so as to cause the ratio of the weight of the fine copper particles to the weight of the coarse copper particles to be in the range of from 1:9 to 5:5, is applied on a substrate by screen printing or flexographic printing to be preliminary-fired with vacuum drying, and then, fired with light irradiation by irradiating light having a wavelength of 200 to 800 nm at a pulse period of 100 to 3000 *µ* m and a pulse voltage of 1600 to 3600 V, to form a conductive film on the substrate.

## Description

### Technical Field

The present invention relates generally to a copper particle dispersing solution. More specifically, the invention relates to a copper particle dispersing solution for use in the production of a conductive film for forming electrodes and circuits of electronic parts and so forth, and a method for producing a conductive film using the same.

### Background Art

As a conventional method for producing a conductive film using a copper particle dispersing solution, there is proposed a method for applying a photosensitive paste, which contains fine inorganic particles, such as fine glass particles, a photosensitive organic constituent, and a compound having an azole structure, such as benzotriazole, on a substrate to expose, develop and fire the paste to form a pattern (of a conductive film) (see, e.g., Japanese Patent Laid-Open No.9-218508).

There is also proposed a method for printing a copper ink solution containing copper nanoparticles (a copper particle dispersing solution) on the surface of a substrate, and then, causing the printed solution to be dried and exposed to pulses for fusing copper nanoparticles with light sintering, to produce a light-sintered copper nanoparticle film (a conductive film) (see, e.g., Japanese Patent Laid-Open No. 2010-528428).

As a copper particle dispersing solution, there is proposed a conductive ink using, as a conductive filler, fine copper particles, on the surface of each of which benzotriazole is deposited as a process for improving resistance to oxidation (see, e.g., Japanese Patent Laid-Open No. 2008-285761).

However, in the method disclosed in Japanese Patent Laid-Open No. 9-218508, it is required to apply the photosensitive paste on the substrate to expose the paste to develop the exposed paste with a developing agent, and then, to fire the developed paste at a high temperature (520 to 610 °C), so that the process is complicated. In addition, it is not possible to fire the paste with light irradiation, and it is not possible to form the pattern on a substrate, which is easily affected by heat, such as a paper or a polyethylene terephthalate (PET) film. In the method disclosed in Japanese Patent Laid-Open No. 2010-528428, the storage stability of the copper ink solution containing copper nanoparticles (the copper particle dispersing solution) is not sufficient. Moreover, if the conductive ink disclosed in Japanese Patent Laid-Open No. 2008-285761 is used as a copper particle dispersing solution for light firing, when the solution is applied on the substrate to be dried and fired with light irradiation to form the conductive film, cracks are formed in the conductive film to deteriorate the electrical conductivity of the film.

### Disclosure of the Invention

It is therefore an object of the present invention to eliminate the aforementioned problems and to provide a copper particle dispersing solution, which has a good storage stability and which is able to form a conductive film having a good electrical conductivity with light firing, and a method for producing a conductive film using the same.

In order to accomplish the aforementioned and other objects, the inventors have diligently studied and found that it is possible to provide a copper particle dispersing solution, which has a good storage stability and which is able to form a conductive film having a good electrical conductivity with light firing, and a method for producing a conductive film using the same, if fine copper particles having an average particle diameter of 1 to 100 nm, each of the fine copper particles being coated with an azole compound, and coarse copper particles having an average particle diameter of 0.3 to 20 *µ*m are dispersed in a dispersing medium.

According to the present invention, there is provided a copper particle dispersing solution comprising: a dispersing medium; fine copper particles having an average particle diameter of 1 to 100 nm dispersed in the dispersing medium, each of the fine copper particles being coated with an azole compound; and coarse copper particles having an average particle diameter of 0.3 to 20 *µ*m dispersed in the dispersing medium. In this copper particle dispersing solution, the total amount of the fine copper particles and coarse copper particles is preferably 50 to 90 % by weight. The weight ratio of the fine copper particles to the coarse copper particles is preferably in the range of from 1:9 to 5:5. The azole compound is preferably benzotriazole, and the dispersing medium is preferably ethylene glycol.

According to the present invention, there is provided a method for producing a conductive film, the method comprising the steps of: applying the above-described copper particle dispersing solution on a substrate; and causing the applied solution to be preliminary-fired and fired with light irradiation to form a conductive film on the substrate. In this method for producing a conductive film, the applying of the copper particle dispersing solution is preferably carried out by screen printing or flexographic printing. The preliminary-firing is preferably carried out by vacuum drying at 50 to 150 °C. The light irradiation is preferably carried out by irradiating with pulsed-light having a wavelength of 200 to 800 nm at a pulse period of 100 to 3000 *µ*s and a pulse voltage of 1600 to 3600 V. The conductive film preferably has a thickness of 1 to 30 *µ*m.

According to the present invention, it is possible to provide a copper particle dispersing solution, which has a good storage stability and which is able to form a conductive film having a good electrical conductivity with light firing, and a method for producing a conductive film using the same.

### Brief Description of the Drawings

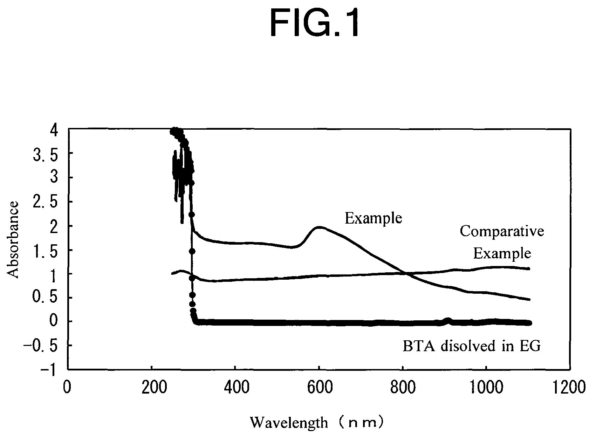

FIG. 1 is a chart showing the absorbance of a dispersing solution containing fine copper particles in each of Example 1 and Comparative Example 1.

### Best Mode for Carrying Out the Invention

In the preferred embodiment of a copper particle dispersing solution according to the present invention, fine copper particles having an average particle diameter of 1 to 100 nm, each of the fine copper particles being coated with an azole compound, and coarse copper particles having an average particle diameter of 0.3 to 20 *µ*m are dispersed in a dispersing medium.

The fine copper particles having an average particle diameter of 1 to 100 nm are easily sintered. If the surface of each of such fine copper particles is coated with an azole compound, it is possible to improve the storage stability of the fine copper particles, and it is possible to improve the light absorbability thereof, so that the fine copper particles are easily sintered with light irradiation. In particular, since the azole compound has a conjugated double band in the molecule thereof, it is designed to absorb light having a wavelength range (200-400 nm) of ultraviolet rays to convert the absorbed light to heat for causing the fine copper particles to be easily sintered.

The coarse copper particles having an average particles diameter of 0.3 to 20 *µ*m are designed to prevent cracks from being formed in the conductive film to deteriorate the electrical conductivity thereof when the copper particles are fired with light irradiation to form the conductive film. The coarse copper particles are also designed to restrain the deterioration of the electrical conductivity of the conductive film even if the thickness thereof is increased.

In this copper particle dispersing solution, the total amount of the fine copper particles and coarse copper particles is preferably 50 to 90 % by weight, and more preferably 60 to 80 % by weight. The ratio of the weight of the fine copper particles to the weight of the coarse copper particles is preferably in the range of from 1:9 to 5:5 (from 1/9 to 5/5). The azole compound is preferably benzotriazole. The dispersing medium may be terpineol, butyl carbitol acetate (BCA), ethylene glycol, diethylene glycol, triethylene glycol or the like, and it is preferably ethylene glycol.

In the preferred embodiment of a method for producing a conductive film according to the present invention, the above-described copper particle dispersing solution is applied on a substrate to be preliminary-fired, and then, fired with light irradiation to form a conductive film on the substrate.

In this method for producing a conductive film, the applying of the copper particle dispersing solution is preferably carried out by screen printing or flexographic printing. In order to cause the copper particle dispersing solution to be suitably applied by such printing, a resin may be added to the copper particle dispersing solution to adjust the viscosity thereof. The preliminary-firing is preferably carried out by vacuum drying at 50 to 150 °C. The light irradiation is preferably carried out by irradiating with light having a wavelength of 200 to 800 nm at a pulse period of 100 to 3000 *µ*s and a pulse voltage of 1600 to 3600 V. The light irradiation can be carried out by irradiating with light by means of a xenon flush lamp or the like, and can be carried out in a short period of time in the atmosphere. The light irradiation may be repeated several times. By this light irradiation, it is possible to form a conductive film which has a thickness of 1 to 30 *µ* m and which has a good electrical conductivity.

Throughout the specification, the expression "average particle diameter" means an average primary particle diameter calculated from a field emission type scanning electron microscope (FE-SEM). The "average primary particle diameter" can be calculated as follows. For example, the fine copper particles or the coarse copper particles are observed by a field emission type scanning electron microscope (FE-SEM) (S-4700 produced by Hitachi Ltd.) at a predetermined magnification (a magnification of 100,000 when the fine copper particles are observed, and a magnification of 2,000 to 20,000 in accordance with the shape and/or size of the coarse copper particles when the coarse copper particles are observed (a magnification of 2,000 in the case of flake-shaped coarse copper particles, a magnification of 5,000 in the case of spherical coarse copper particles having an average particle diameter of 3.0 *µ*m, and a magnification of 20,000 in the case of spherical coarse copper particles having an average particle diameter of 0.5 *µ*m)). Then, optional 100 fine copper particles or 100 coarse copper particle on the FE-SEM image (a plurality of images if necessary) are selected at random. Then, the particle diameter (the long diameter on the image) of each of the selected particles (primary particles) is measured. By the number average of the measured particle diameters, the average particle diameter of the coarse or fine copper particles can be calculated (as the number average particle diameter).

Examples of a copper particle dispersing solution and a method for producing a conductive film using the same according to the present invention will be described below in detail.

### Example 1

First, there were prepared 280 g of copper sulfate pentahydrate serving as a copper source, 1 g of benzotriazole (BTA) serving as a dispersing agent, a solution A obtained by dissolving 1 g of a water-based antifrothing agent (ANTIFLOTH F244 commercially available from DKS Co., Ltd.) in 1330 g of water, a solution B obtained by allowing 200 g of an aqueous solution containing 50 % by weight of sodium hydroxide serving as a neutralizer to be diluted with 900 g of water, and a solution C obtained by allowing 150 g of an aqueous solution containing 80 % by weight of hydrazine monohydrate as a reducing agent to be diluted with 1300 g of water.

Then, the solution A and the solution B were mixed with each other while being stirred, and the temperature of the mixed solution was adjusted to 60 °C. Thereafter, while maintaining the stirring, all of the solution C was added to the mixed solution within 30 seconds. After about 5 minutes, the reaction was completed to produce a slurry. The solid-liquid separation of the slurry was carried out to obtain a solid material. Then, ethylene glycol was allowed to pass through the solid material to obtain a dispersing solution in which fine copper particles coated with BTA are dispersed in ethylene glycol. The fine copper particles in this dispersing solution were observed by a field emission type scanning electron microscope (FE-SEM) (S-4700 produced by Hitachi Ltd.). As a result, the fine copper particles were substantially spherical fine particles (coated with BTA). The average particle diameter of the fine copper particles was calculated. As a result, the average particle diameter thereof was about 50 nm. The content of copper in the dispersing solution was obtained by the differential analysis of the dispersing solution in N₂. As a result, the content of copper therein was 68 % by weight.

Then, flake-shaped copper particles having an average particle diameter of 12 *µ*m were added to the dispersing solution of the fine copper particles coated with BTA (so that the ratio of the weight of the fine copper particles coated with BTA to the weight of the flake-shaped copper particles was 3:7). Thus, there was obtained a copper particle dispersing solution containing the fine copper particles coated with BTA (filler 1) and the flake-shaped copper particles (filler 2) as conductive fillers. Furthermore, ethylene glycol was add to the copper particle dispersing solution to be adjusted so that the content of the conductive fillers therein was 67 % by weight.

Then, a screen printing plate (a screen printing plate having the number of meshes of 500 LPI, a wire diameter of 18 *µ*m, a gauze thickness of 29 *µ*m, an emulsion thickness of 5 *µ*m, commercially available from SONOCOM Co., Ltd.) was used for causing the above-described copper particle dispersing solution to be printed in a substantially rectangular shape having a size of 50 mm x 0.5 mm on a substrate (an ink jet printing paper commercially available from Eastman Kodak Company) once (as the number of repeated printing) by screen printing. After the printed dispersing solution was vacuum dried at 100 °C for 60 minutes as preliminary-firing to obtain a preliminary-fired film, a pulse irradiating apparatus (Sinteron 2000 produced by Xenon Corporation) was used for irradiating the preliminary-fired film with light having a wavelength of 200 to 800 nm at a pulse period of 2000 *µ*s and a pulse voltage of 2000 V by means of a xenon flash lump to fire the preliminary-fired film to obtain a conductive film. The thickness of the conductive film was obtained by calculating an average value of height differences between the surface of the conductive film and the surface of the substrate having the conductive film, the height differences being measured at 100 spots by a laser microscope (VK-9700 produced by KEYENCE CORPORATION). As a result, the thickness of the conductive film was 7.0 *µ*m. The electrical resistance (line resistance) of the conductive film was measured by a tester (CDM-03D produced by CUSTOM CORPORATION). As a result, the electrical resistance was 9.8 Ω. The volume resistivity of the conductive film was obtained from the thickness, electrical resistance and area of the conductive film. As a result, the volume resistivity was 69 *µ* Ω · cm.

Then, a flexographic printing plate was used for causing the above-described copper particle dispersing solution to be printed in a substantially rectangular shape having a size of 140 mm x 5 mm on a substrate (an ink jet printing paper commercially available from Eastman Kodak Company) at an anilox volume of 20 cc/m² once (as the number of repeated printing) by flexographic printing. After the printed dispersing solution was vacuum dried at 50 °C for 60 minutes as preliminary-firing to obtain a preliminary-fired film, the above-described pulse irradiating apparatus was used for irradiating the preliminary-fired film with light at a pulse period of 2000 *µ*s and a pulse voltage of 2000 V to fire the preliminary-fired film to obtain a conductive film. The thickness of the conductive film was obtained by the same method as the above-described method. As a result, the thickness of the conductive film was 2 *µ*m. The electrical resistance (line resistance) of the conductive film was measured by the above-described tester. As a result, the electrical resistance was 1.7 Q. The volume resistivity of the conductive film was obtained from the thickness, electrical resistance and area of the conductive film. As a result, the volume resistivity was 12 *µ* Ω · cm.

Then, a flexographic printing plate was used for causing the above-described copper particle dispersing solution to be printed in a substantially rectangular shape having a size of 140 mm x 5 mm on a substrate (an ink jet printing paper commercially available from Eastman Kodak Company) at an anilox volume of 20 cc/m² twice (as the number of repeated printing) by flexographic printing. After the printed dispersing solution was vacuum dried at 50 °C for 60 minutes as preliminary-firing to obtain a preliminary-fired film, the above-described pulse irradiating apparatus was used for irradiating the preliminary-fired film with light at a pulse period of 2000 *µ*s and a pulse voltage of 2000 V to fire the preliminary-fired film to obtain a conductive film. The thickness of the conductive film was obtained by the same method as the above-described method. As a result, the thickness of the conductive film was 4 *µ*m. The electrical resistance (line resistance) of the conductive film was measured by the above-described tester. As a result, the electrical resistance was 1.0 Ω. The volume resistivity of the conductive film was obtained from the thickness, electrical resistance and area of the conductive film. As a result, the volume resistivity was 14 *µ* Ω · cm.

Then, a flexographic printing plate was used for causing the above-described copper particle dispersing solution to be printed in a substantially rectangular shape having a size of 140 mm x 5 mm on a substrate (an ink jet printing paper commercially available from Eastman Kodak Company) at an anilox volume of 20 cc/m² three times (as the number of repeated printing) by flexographic printing. After the printed dispersing solution was vacuum dried at 50 °C for 60 minutes as preliminary-firing to obtain a preliminary-fired film, the above-described pulse irradiating apparatus was used for irradiating the preliminary-fired film with light at a pulse period of 2000 *µ*s and a pulse voltage of 2000 V to fire the preliminary-fired film to obtain a conductive film. The thickness of the conductive film was obtained by the same method as the above-described method. As a result, the thickness of the conductive film was 6 *µ*m. The electrical resistance (line resistance) of the conductive film was measured by the above-described tester. As a result, the electrical resistance was 0.6 Ω. The volume resistivity of the conductive film was obtained from the thickness, electrical resistance and area of the conductive film. As a result, the volume resistivity was 13 *µ*Ω · cm.

After the copper particle dispersing solution obtained in this example was allowed to stand at room temperature in an atmosphere of nitrogen for one month, the presence of aggregation was checked with eyes. As a result, no aggregation was observed. The copper particle dispersing solution after being thus allowed to stand for one month was used for producing a conductive film by the same method as the above-described method. As a result, the electrical resistance and volume resistivity of the conductive film were hardly varied.

### Comparative Example 1

A copper particle dispersing solution (conductive filler: 67 % by weight) was obtained by the same method as that in Example 1, except that the solution A contained no benzotriazole (BTA) serving as the dispersing agent. Furthermore, the fine copper particles in this dispersing solution were observed by a field emission type scanning electron microscope (FE-SEM) (S-4700 produced by Hitachi Ltd.). As a result, the fine copper particles were substantially spherical fine particles. The average particle diameter of the fine copper particles was calculated. As a result, the average particle diameter thereof was about 50 nm.

This copper particle dispersing solution was used for producing a conductive film by the same method as that in Example 1. Then, the electrical resistance (line resistance) of the conductive film was measured by the same method as that in Example 1, and the thickness and volume resistivity thereof were obtained by the same methods as those in Example 1. As a result, with respect to the conductive film obtained by printing the copper particle dispersing solution by screen printing, the electrical resistance (line resistance) thereof was 54 Ω, the thickness thereof was 7.0 *µ*m, and the volume resistivity thereof was 378 *µ* Ω · cm. With respect to the conductive films obtained by printing the copper particle dispersing solution by flexographic printing, when the thickness thereof was 2 *µ*m and 4 *µ*m, it was not possible to measure the electrical resistance (line resistance) thereof due to overload (OL), so that it was not possible to obtain the volume resistivity thereof. When the thickness thereof was 6 *µ*m, the electrical resistance (line resistance) thereof was 20.6 Ω, and the volume resistivity thereof was 441 *µ* Ω · cm.

After the copper particle dispersing solution obtained in this comparative example was allowed to stand at room temperature in an atmosphere of nitrogen for one month, the presence of aggregation was checked with eyes. As a result, change of color due to oxidation was observed, and aggregation was observed.

### Comparative Example 2

A copper particle dispersing solution (conductive filler: 67 % by weight) containing benzotriazole (BTA) was obtained by adding BTA to a conductive filler dispersing solution so that the amount of BTA was 2 % by weight with respect to the fine copper particles, the conductive filler dispersing solution being obtained by the same method as that in Example 1, except that the solution A contained no BTA serving as the dispersing agent. Furthermore, the fine copper particles in this dispersing solution were observed by a field emission type scanning electron microscope (FE-SEM) (S-4700 produced by Hitachi Ltd.). As a result, the fine copper particles were substantially spherical fine particles. The average particle diameter of the fine copper particles was calculated. As a result, the average particle diameter thereof was about 50 nm.

This copper particle dispersing solution was used for producing a conductive film by the same method as that in Example 1. Then, the electrical resistance (line resistance) of the conductive film was measured by the same method as that in Example 1, and the thickness and volume resistivity thereof were obtained by the same methods as those in Example 1. As a result, with respect to the conductive film obtained by printing the copper particle dispersing solution by screen printing, the electrical resistance (line resistance) thereof was 19.2 Ω, the thickness thereof was 7.0 *µ*m, and the volume resistivity thereof was 134 *µ* Ω · cm. With respect to the conductive films obtained by printing the copper particle dispersing solution by flexographic printing, when the thickness thereof was 2 *µ*m and 4 *µ*m, it was not possible to measure the electrical resistance (line resistance) thereof due to overload (OL), so that it was not possible to obtain the volume resistivity thereof. When the thickness thereof was 6 *µ*m, the electrical resistance (line resistance) thereof was 21.7 Ω, and the volume resistivity thereof was 465 *µ* Ω · cm.

After the copper particle dispersing solution obtained in this comparative example was allowed to stand at room temperature in an atmosphere of nitrogen for one month, the presence of aggregation was checked with eyes. As a result, change of color due to oxidation was observed, and aggregation was observed.

### Example 2

A copper particle dispersing solution (conductive filler: 67 % by weight) was obtained by the same method as that in Example 1, except that the ratio of the weight of the fine copper particles coated with BTA to the weight of the flake-shaped copper particles was 5:5.

This copper particle dispersing solution was used for producing a conductive film by flexographic printing by the same method as that in Example 1. Then, the electrical resistance (line resistance) of the conductive film was measured by the same method as that in Example 1, and the volume resistivity thereof was obtained by the same method as that in Example 1. As a result, when the thickness of the conductive film was 2 *µ*m, the electrical resistance (line resistance) thereof was 1.5 Ω, and the volume resistivity thereof was 11 *µ* Ω cm. When the thickness of the conductive film was 4 *µ*m, the electrical resistance (line resistance) thereof was 1.2 Ω, and the volume resistivity thereof was 17 *µ* Ω · cm. When the thickness of the conductive film was 6 *µ*m, the electrical resistance (line resistance) thereof was 1.3 Ω, and the volume resistivity thereof was 28 *µ* Ω · cm.

After the copper particle dispersing solution obtained in this example was allowed to stand at room temperature in an atmosphere of nitrogen for one month, the presence of aggregation was checked with eyes. As a result, no aggregation was observed. The copper particle dispersing solution after being thus allowed to stand for one month was used for producing a conductive film by the same method as the above-described method. As a result, the electrical resistance and volume resistivity of the conductive film were hardly varied.

### Example 3∼5

Copper particle dispersing solutions (conductive filler: 67 % by weight) were obtained by the same method as that in Example 1, except that spherical copper particles having an average particle diameter of 0.5 *µ*m were used in place of the flake-shaped copper particles and that the ratio of the weight of the fine copper particles coated with BTA to the weight of the spherical copper particles was 1:9 (Example 3), 3:7 (Example 4) and 5:5 (Example 5), respectively.

These copper particle dispersing solutions were used for producing conductive films by flexographic printing by the same method as that in Example 1. Then, the electrical resistance (line resistance) of each of the conductive films was measured by the same method as that in Example 1, and the volume resistivity thereof was obtained by the same method as that in Example 1. As a result, with respect to the conductive film obtained by using the copper particle dispersing solution in Example 3, when the thickness of the conductive film was 2 *µ*m, the electrical resistance (line resistance) thereof was 8.1 Ω, and the volume resistivity thereof was 58 *µ* Ω · cm. When the thickness of the conductive film was 4 *µ*m, the electrical resistance (line resistance) thereof was 6.9 Ω, and the volume resistivity thereof was 99 *µ* Ω · cm. When the thickness of the conductive film was 6 *µ*m, the electrical resistance (line resistance) thereof was 3.3 Ω, and the volume resistivity thereof was 71 *µ* Ω · cm. With respect to the conductive film obtained by using the copper particle dispersing solution in Example 4, when the thickness of the conductive film was 2 *µ*m, the electrical resistance (line resistance) thereof was 9.4 Ω, and the volume resistivity thereof was 67 *µ* Ω · cm. When the thickness of the conductive film was 4 *µ*m, the electrical resistance (line resistance) thereof was 5.1 Ω, and the volume resistivity thereof was 73 *µ* Ω · cm. When the thickness of the conductive film was 6 *µ*m, the electrical resistance (line resistance) thereof was 3.3 Ω, and the volume resistivity thereof was 71 *µ* Ω · cm. With respect to the conductive film obtained by using the copper particle dispersing solution in Example 5, when the thickness of the conductive film was 2 *µ*m, the electrical resistance (line resistance) thereof was 2.6 Ω, and the volume resistivity thereof was 19 *µ*Ω · cm. When the thickness of the conductive film was 4 *µ*m, the electrical resistance (line resistance) thereof was 1.9 Ω, and the volume resistivity thereof was 27 *µ* Ω · cm. When the thickness of the conductive film was 6 *µ*m, the electrical resistance (line resistance) thereof was 1.4 Ω, and the volume resistivity thereof was 30 *µ* Ω · cm.

After each of the copper particle dispersing solutions obtained in these examples was allowed to stand at room temperature in an atmosphere of nitrogen for one month, the presence of aggregation was checked with eyes. As a result, no aggregation was observed. The copper particle dispersing solutions after being thus allowed to stand for one month were used for producing conductive films by the same method as the above-described method. As a result, the electrical resistance and volume resistivity of each of the conductive films were hardly varied.

### Example 6-7

Copper particle dispersing solutions (conductive filler: 67 % by weight) were obtained by the same method as that in Example 1, except that spherical copper particles having an average particle diameter of 3.0 *µ*m were used in place of the flake-shaped copper particles and that the ratio of the weight of the fine copper particles coated with BTA to the weight of the spherical copper particles was 3:7 (Example 6) and 5:5 (Example 7), respectively.

These copper particle dispersing solutions were used for producing conductive films by flexographic printing by the same method as that in Example 1. Then, the electrical resistance (line resistance) of each of the conductive films was measured by the same method as that in Example 1, and the volume resistivity thereof was obtained by the same method as that in Example 1. As a result, with respect to the conductive film obtained by using the copper particle dispersing solution in Example 6, when the thickness of the conductive film was 2 *µ*m, the electrical resistance (line resistance) thereof was 3.1 Ω, and the volume resistivity thereof was 22 *µ* Ω cm. When the thickness of the conductive film was 4 *µ*m, the electrical resistance (line resistance) thereof was 1.4 Ω, and the volume resistivity thereof was 20 *µ* Ω · cm. When the thickness of the conductive film was 6 *µ*m, the electrical resistance (line resistance) thereof was 1.2 Ω, and the volume resistivity thereof was 26 *µ* Ω · cm. With respect to the conductive film obtained by using the copper particle dispersing solution in Example 7, when the thickness of the conductive film was 2 *µ*m, the electrical resistance (line resistance) thereof was 4.0 Ω, and the volume resistivity thereof was 29 *µ* Ω · cm. When the thickness of the conductive film was 4 *µ*m, the electrical resistance (line resistance) thereof was 2.8 Ω, and the volume resistivity thereof was 40 *µ*Ω · cm. When the thickness of the conductive film was 6 *µ*m, the electrical resistance (line resistance) thereof was 3.6 Ω, and the volume resistivity thereof was 77 *µ* Ω · cm.

After each of the copper particle dispersing solutions obtained in these examples was allowed to stand at room temperature in an atmosphere of nitrogen for one month, the presence of aggregation was checked with eyes. As a result, no aggregation was observed. The copper particle dispersing solutions after being thus allowed to stand for one month were used for producing conductive films by the same method as the above-described method. As a result, the electrical resistance and volume resistivity of each of the conductive films were hardly varied.

### Comparative Example 3

A copper particle dispersing solution (conductive filler: 67 % by weight) was obtained by the same method as that in Example 1, except that the flake-shaped copper particles were not used.

This copper particle dispersing solution was used for producing a conductive film by flexographic printing by the same method as that in Example 1. Then, the electrical resistance (line resistance) of the conductive film was measured by the same method as that in Example 1, and the volume resistivity thereof was obtained by the same method as that in Example 1. As a result, when the thickness of the conductive film was 4 *µ*m, the electrical resistance (line resistance) thereof was 82.0 Ω, and the volume resistivity thereof was 11.71 *µ* Ω · cm. When the thickness of the conductive film was 6 *µ*m, it was not possible to measure the electrical resistance (line resistance) thereof due to overload (OL), so that it was not possible to obtain the volume resistivity thereof.

After the copper particle dispersing solution obtained in this example was allowed to stand at room temperature in an atmosphere of nitrogen for one month, the presence of aggregation was checked with eyes. As a result, no aggregation was observed.

Tables 1 through 3 show the producing conditions of the copper particle dispersing solutions in these examples and comparative examples, and the line resistance and volume resistivity of each of the conductive films produced by using the copper particle dispersing solutions.

**Table 1**

| | Coating of Fine Copper Particles | Shape and Diameter of Coarse Copper Particles | Blending Ratio (Fine Copper Particles: Coarse Copper Particles) | Additive |
|---|---|---|---|---|
| Ex. 1 | BTA | Flake-shaped 12µm | 3 : 7 | - |
| Comp.1 | - | Flake-shaped 12µm | 3 : 7 | - |
| Comp.2 | - | Flake-shaped 12µm | 3 : 7 | BTA |
| Ex.2 | BTA | Flake-shaped 12µm | 5 : 5 | - |
| Ex.3 | BTA | Spherical 0.5µm | 1 : 9 | - |
| Ex.4 | BTA | Spherical 0.5µm | 3 : 7 | - |
| Ex.5 | BTA | Spherical 0.5µm | 5 : 5 | - |
| Ex.6 | BTA | Spherical 3.0µm | 3 : 7 | - |
| Ex.7 | BTA | Spherical 3.0µm | 5 : 5 | - |
| Comp.3 | BTA | - | 10 : 0 | - |

**Table 2**

| | Line Resistance (Ω) | Volume Resistivity (µΩ · cm) |
|---|---|---|
| Ex.1 | 9.8 | 69 |
| Comp.1 | 54 | 378 |
| Comp.2 | 19.2 | 134 |

**Table 3**

| | Anilox Volume (cc/m²) | Thickness (µm) | Line Resistance (Ω) | Volume Resistivity (µΩ · cm) |
|---|---|---|---|---|
| Ex.1 | 20×1 | 2.0 | 1.7 | 12 |
| | 20×2 | 4.0 | 1.0 | 14 |
| | 20×3 | 6.0 | 0.6 | 13 |
| Comp.1 | 20×1 | 2.0 | OL | OL |
| | 20×2 | 4.0 | OL | OL |
| | 20×3 | 6.0 | 20.6 | 441 |
| Comp.2 | 20×1 | 2.0 | OL | OL |
| | 20×2 | 4.0 | OL | OL |
| | 20×3 | 6.0 | 21.7 | 465 |
| Ex.2 | 20×1 | 2.0 | 1.5 | 11 |
| | 20×2 | 4.0 | 1.2 | 17 |
| | 20×3 | 6.0 | 1.3 | 28 |
| Ex.3 | 20×1 | 2.0 | 8.1 | 58 |
| | 20×2 | 4.0 | 6.9 | 99 |
| | 20×3 | 6.0 | 3.3 | 71 |
| Ex.4 | 20×1 | 2.0 | 9.4 | 67 |
| | 20×2 | 4.0 | 5.1 | 73 |
| | 20×3 | 6.0 | 3 . 3 | 71 |
| Ex.5 | 20×1 | 2.0 | 2.6 | 19 |
| | 20×2 | 4.0 | 1.9 | 27 |
| | 20×3 | 6.0 | 1.4 | 30 |
| Ex.6 | 20×1 | 2.0 | 3.1 | 22 |
| | 20×2 | 4.0 | 1.4 | 20 |
| | 20×3 | 6.0 | 1.2 | 26 |
| Ex.7 | 20×1 | 2.0 | 4.0 | 29 |
| | 20×2 | 4.0 | 2.8 | 40 |
| | 20×3 | 6.0 | 3.6 | 77 |
| Comp.3 | 20×2 | 4.0 | 82.0 | 1171 |
| | 20×3 | 6.0 | OL | OL |

FIG. 1 shows the absorbance of dispersing solutions, in which about 0.05 % by weight of the fine copper particles (coated with BTA) in Example 1 and about 0.05 % by weight of fine copper particles (not coated with BTA) in Comparative Example 1 were added to ethylene glycol (EG), respectively, to be dispersed with ultrasonic waves, when the absorbance was measured at a wavelength of 250 to 1100 nm by means of an ultraviolet and visible spectrophotometer (UV-1800 produced by Shimadzu Corporation). As shown in FIG. 1, in the solution in which BTA is dissolved in EG, the absorbance is increased at a wavelength of 300 nm or less due to the presence of the conjugated double band which absorbs light in the range of ultraviolet rays. Also, in the dispersing solution of the fine copper particles (coated with BTA) in Example 1, the absorbance is increased at a wavelength of 300 nm or less due to BTA coating the fine copper particles. However, it can be seen that the absorbance is not increased at a wavelength of 300 nm or less in the dispersing solution of the fine copper particles (not coated with BTA) in Comparative Example 1.

If a conductive film produced from a copper particle dispersing solution according to the present invention is used for forming an antenna for an RFID tag, such as an IC tag, which is incorporated to produce an inlay (comprising an IC chip and an antenna), it is possible to produce an FEID tag, such as an IC tag, which has a practical communication range.

## Claims

1. A copper particle dispersing solution comprising:
a dispersing medium;
fine copper particles having an average particle diameter of 1 to 100 nm dispersed in the dispersing medium, each of the fine copper particles being coated with an azole compound; and
coarse copper particles having an average particle diameter of 0.3 to 20 *µ*m dispersed in the dispersing medium.

2. A copper particle dispersing solution as set forth in claim 1, wherein a total amount of said fine copper particles and coarse copper particles is 50 to 90 % by weight in said copper particle dispersing solution.

3. A copper particles dispersing solution as set forth in claim 1, wherein a weight ratio of said fine copper particles to said coarse copper particles is in the range of from 1:9 to 5:5.

4. A copper particles dispersing solution as set forth in claim 1, wherein said azole compound is benzotriazole.

5. A copper particle dispersing solution as set forth in claim 1, wherein said dispersing medium is ethylene glycol.

6. A method for producing a conductive film, the method comprising the steps of:
applying a copper particle dispersing solution as set forth in any one of claims 1 through 5, on a substrate; and
causing the applied solution to be preliminary-fired and fired with light irradiation to form a conductive film on the substrate.

7. A method for producing a conductive film as set forth in claim 6, wherein said applying of the copper particle dispersing solution is carried out by screen printing or flexographic printing.

8. A method for producing a conductive film as set forth in claim 6, wherein said preliminary-firing is carried out by vacuum drying at 50 to 150 °C.

9. A method for producing a conductive film as set forth in claim 6, wherein said light irradiation is carried out by irradiating with light having a wavelength of 200 to 800 nm at a pulse period of 100 to 3000 *µ*s and a pulse voltage of 1600 to 3600 V.

10. A method for producing a conductive film as set forth in claim 6, wherein said conductive film has a thickness of 1 to 30 *µ*m.
